Europäisches Patentamt

European Patent Office

Office européen des brevets

(19)

(11) EP 0 681 314 B1

(12) **EUROPÄISCHE PATENTSCHRIFT**

(45) Veröffentlichungstag und Bekanntmachung des Hinweises auf die Patenterteilung:
**16.12.1998 Patentblatt 1998/51**

(51) Int Cl.⁶: **H01L 21/20**, C30B 25/02, C30B 25/18, C30B 23/02

(21) Anmeldenummer: **95105623.3**

(22) Anmeldetag: **13.04.1995**

(54) **Komposit-Struktur für elektronische Bauteile und Verfahren zu deren Herstellung**

Composite structure for electronic devices and method of making the same

Structure composite pour dispositif électronique et procédé de fabrication

(84) Benannte Vertragsstaaten:
**DE FR GB IT**

(30) Priorität: **04.05.1994 DE 4415601**

(43) Veröffentlichungstag der Anmeldung:
**08.11.1995 Patentblatt 1995/45**

(73) Patentinhaber: **DAIMLER-BENZ AKTIENGESELLSCHAFT**
**70567 Stuttgart (DE)**

(72) Erfinder:
• **Zachai, Reinhard, Dr.**
**D-89312 Günzburg (DE)**

• **Füsser, Hans-Jürgen, Dr.**
**D-89547 Gerstetten-Dettingen (DE)**
• **Gutheit, Tim**
**D-89073 Ulm (DE)**

(56) Entgegenhaltungen:
EP-A- 0 282 054    EP-A- 0 457 508
US-A- 4 177 321    US-A- 5 006 203
US-A- 5 236 545

• PATENT ABSTRACTS OF JAPAN vol. 010, no. 289 (E-442), 2.Oktober 1986 & JP-A-61 107721 (MATSUSHITA ELECTRIC IND CO LTD), 26.Mai 1986,

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft ein Komposit-Struktur für elektronische Bauteile gemäß dem Oberbegriff des Anspruchs 1 bzw. bzgl. dem Verfahren nach dem Oberbegriff des Anspruchs 10, wie beides aus der EP 282 054 A1 als bekannt hervorgeht.

Die EP 282 054 A1 betrifft eine Komposit-Struktur für elektronische Bauteile und ein Verfahren zur Herstellung derartiger Komposit-Strukturen. Die Komposit-Struktur umfaßt ein Wachstum-Substrat aus kristallinem Si (Silizium) oder aus kristallinem GaAs Galliumarsenid), auf dem eine Zwischenschicht aus kristallinem SiC (Siliziumkarbid) abgeschieden ist und eine auf der Zwischenschicht abgeschieden Diamantschicht, wobei die Schichten mittels CVD (chemical-vapor-deposition) auf dem Wachstum-Substrat abgeschieden werden. Die Zwischenschicht aus SiC dient hierbei dazu, die zwischen dem Wachstum-Subtrat, deren Gitterkonstante etwa 5,43 Å (Si) bzw. 5,65 Å (GaAs) einerseits und der aufzubringenden Diamantschicht mit eine Gitterkonstanten von etwa 3,57 Å andererseits herrschende Gitterfehlanpassung, bezogen auf die Gitterkonstante der Diamantschicht von etwa 52% bzw. etwa 58% abzubauen, um dadurch ein akzeptables Wachstum der Diamantschicht auf derartigen Wachstum-Substraten zu ermöglichen. Da SiC eine Gitterkonstante von etwa 4,36 Å hat, beträgt dessen Gitterfehlanpassung, bezogen auf die Gitterkonstante des Wachstum-Substrats etwa 25 % (Si) bzw. 30 % (GaAs), und hinsichtlich der Diamantschicht 22%, wobei hier die Differenz auf die Gitterkonstante der Diamantschicht bezogen ist. Durch eine Verspannung der die kristallinen SiC-Schicht wird die Auswirkungen der vorliegende Gitterfehlanpassung auf die Qualität der abgeschiedenen Diamantschicht verringert. Trotz dieser Maßnahme ist die Qualität der abgeschiedenen Diamantschicht aber immer noch unbefriedigend.

Aus der JP-A 61107721 in Patent Abstracts of Japan, Vol. 10, No. 289 (E-442) vom 2. Oktober 1986 ist eine Komposit-Struktur für mikroelektronische Bauteile bekannt, die eine Zwischenschicht zum Abbau einer Gitterfehlanpassung aufweist. Die Zwischenschicht ist aus mehreren kristallischen Einzelschichten gebildet, deren Gitterkonstante sich mit zunehmender Schichtdicke der Zwischenschicht stufenartig verändert.

Die Aufgabe der Erfindung ist es, die gattungsgemäß zugrundegelegte Komposit-Struktur dahingehend weiterzuentwickeln, daß die Qualität einer auf Wachstum-Substraten angeordneten Diamantschicht verbessert ist. Desweiteren ist es Aufgabe der Erfindung ein Verfahren zur Herstellung einer auf derartigen Wachstum-Substraten angeordneten Diamantschicht zu entwickeln.

Die Aufgabe wird bei einer zugrundegelegten Komposit-Struktur mit den kennzeichnenden Merkmalen des Anspruchs 1, bzw. bzgl. des Verfahrens mit den kennzeichnenden Verfahrensschritten des Anspruchs 10 gelöst. Die Gitterkonstante des Zwischengitters weist entlang der Dickenerstreckung der Zwischenschicht keinen konstanten Wert auf, sondern ist anfangs an die Gitterkonstante des Wachstum-Substrats weitgehend angepaßt und nähert sich mit zunehmender Dickenerstreckung der Zwischenschicht kontinuierlich einer Gitterkonstanten, die mit der Gitterkonstanten des Diamanten ein ganzzahliges Verhältnis, bspw. 1 : 1 oder 2 : 3, aufweist. In diesen Fällen ist die Verspannung an den Grenzflächen zwischen den jeweiligen Schichten (Wachstumsseite des Wachstum-Substrats/Zwischenschicht und Zwischenschicht/Diamantschicht) weitgehend abgebaut. Dies ermöglicht eine gute Qualität und insbesondere eine verbesserte orientierte Abscheidung der abgeschiedenen Diamantschicht. Die Abscheidung der Zwischenschicht kann mittels den bekannten Epitaxie-Verfahren vorgenommen werden, wobei sich MBE (molecular-beam-epitaxy) und RF- oder Mikrowellen-Plasma-MBE oder CVD (chemical-vapor-deposition) besonders empfehlen.

Da bei der Erfindung die Komposit-Struktur bei guter Qualität der Diamantschicht als Wachstum-Substrat ein handelsübliches und billiges Wachstum-Substrat, insbesondere ein Wachstum-Substrat aus Si oder GaAs aufweisen kann, deren Gitterkonstante von der Gitterkonstanten der Diamantschicht, bezogen auf die Gitterkonstante des Diamanten, um mehr als 25% differiert, kann eine derartige Komposit-Struktur kostengünstig hergestellt werden.

Von besonderem Vorteil ist es, wenn die Gitterkonstante der Zwischenschicht derart modifiziert ist, daß am Übergang der Zwischenschicht zur Diamantschicht hin die Differenz eines ganzzahligen Vielfachen der Gitterkonstanten der Zwischenschicht und eines ganzzahligen Vielfachen der Gitterkonstante der Diamantschicht, bezogen auf das gleiche ganzzahlige Vielfache der Gitterkonstanten der Zwischenschicht, kleiner als 10% und idealerweise etwa null ist.

Hierbei muß die Zwischenschicht nicht über die gesamte Wachstumsseite des Wachstumssubstrat abgeschieden sein. Vielmehr genügt ein sogenanntes Inselwachstum; d.h. die Zwischenschicht kann in begrenzten Regionen abgeschieden sein. In einigen Fällen kann dieses Inselwachstum, das insbesondere bei hohem Kohlenstoffanteil auftritt, sogar das Diamantwachstum noch begünstigen.

Zweckmäßige Ausgestaltungen der Erfindung sind den Unteransprüchen entnehmbar. Im übrigen wird die Erfindung anhand von in den Figuren dargestellten Ausführungsbeispielen im folgenden erläutert. Dabei zeigt

Fig. 1    einen schematische Darstellung eines Schnittes durch eine erfindungsgemäße Komposit-Struktur mit einer Legierung als Zwischenschicht,

Fig. 2    ein Diagramm des Verlaufes der Gitterkonstanten der Komposit-Struktur nach Figur 1, mit einer modifizierten Gitteranpassung zwischen der Zwischenschicht und der Diamantschicht von 1 : 1,

Fig. 3 einen schematische Darstellung eines Schnittes durch eine erfindungsgemäße Komposit-Struktur mit einer Zwischenschicht, die aus einem Bereich des Wachstum-Substrats gebildet ist, in die Kohlenstoffatome eingebracht sind und

Fig. 4 ein Diagramm des Verlaufes der Gitterkonstanten der Komposit-Struktur nach Figur 3, mit einer modifizierten Gitteranpassung zwischen der Zwischenschicht und der Diamantschicht von 2 : 3,

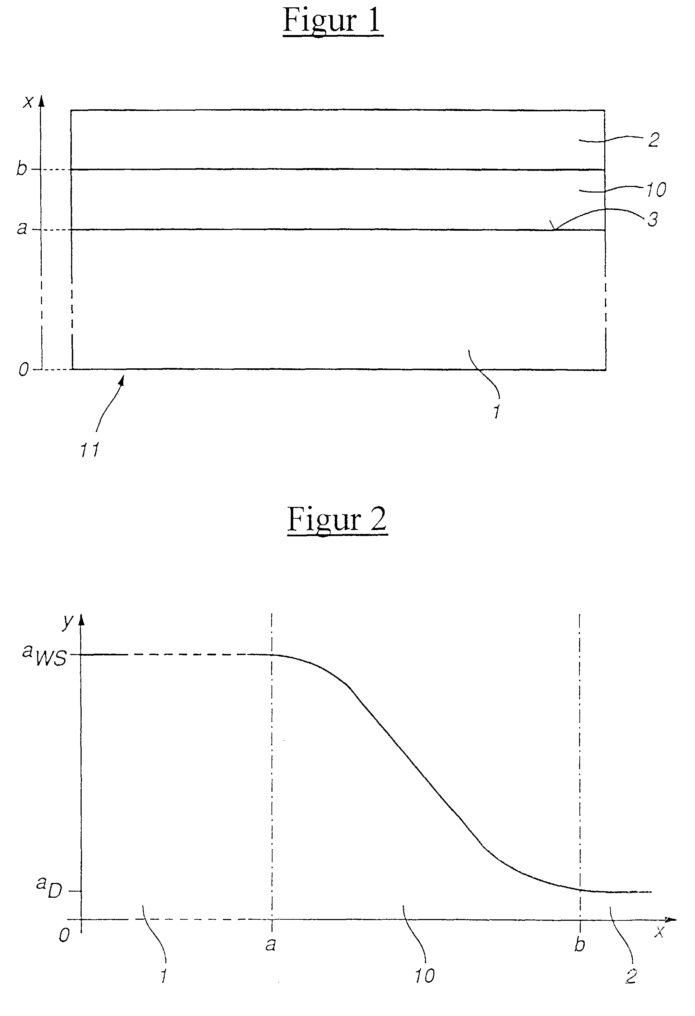

In Figur 1 ist ein Schnitt durch eine erfindungsgemäße Komposit-Struktur 11 für elektronische Bauteile dargestellt. Die Komposit-Struktur 11 weist ein weitgehend monokristallines Wachstum-Substrat 1 auf, auf deren zuvor gereinigte Wachstumsseite 3 eine Silizium-Kohlenstoff-Legierung abgeschieden ist. Die Legierung weist in kristallographischer Hinsicht im wesentlichen eine zinkblende- oder eine diamant- oder eine calcium-fluoridähnliche ($CaF_2$) Gitterstruktur auf, wobei die Legierungsatome (Si und C) innerhalb des Legierungsgitters statistisch verteilt sind. Das Kristallgitter der als Legierung ausgeführten Zwischenschicht 10, 30 weist gegenüber dem Kristallgitter des Wachstum-Substrats 1 eine feste Orientierung auf, wobei an dem Kristallgitter der Zwischenschicht wiederum 20 % bis 100 % der Kristallite der Diamantschicht 2 mit Abmessungen zwischen 0,1 μm und 200 μm ausgerichtet sind. Die Ausrichtung der Kristallite ist hierbei insbesondere so beschaffen, daß im Rahmen einer möglichen Fehlorientierung von weniger als 10 ° die einander entsprechenden Kristallrichtungen (Miller'sche Indizes hkl) in der Zwischenschicht 10 und den Kristalliten parallel zueinander sind. Auf dieser Legierung wird anschließend eine Diamantschicht 2 aufgebracht.

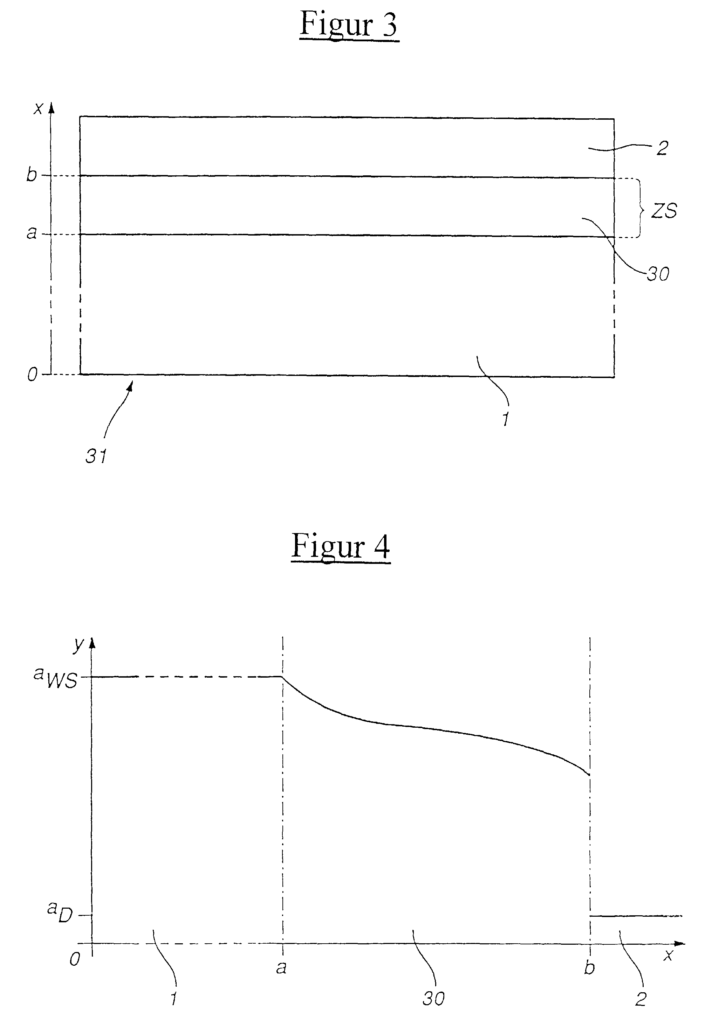

In Figur 2 ist die Änderung der Gitterkonstanten des Komposit-Substrats 11 dargestellt, wobei entlang der x-Achse die Dickenerstreckung der Komposit-Struktur 11 und entlang der y-Achse die jeweilige Gitterkonstante im Bereich der jeweiligen Schicht, also des Wachstum-Substrats 1, der Si-C-Legierung (Zwischenschicht 10) und der Diamantschicht 2, aufgetragen ist. Die Grenzen zwischen den unterschiedlichen Schichten sind mit "0", Beginn des Wachstum-Substrats 1, mit "a", Beginn der Zwischenschicht 10 und mit "b", dem Beginn der Diamantschicht 2 gekennzeichnet.

Gemäß des Diagramms nach Figur 2 ändert sich die Gitterkonstante des Legierungsgitters mit zunehmender Dickenerstreckung der Zwischenschicht 10, also mit zunehmendem Abstand zum Wachstum-Substrat 1, wobei in der Legierung der Kohlenstoffanteil zunimmt und der Siliziumanteil abnimmt. Mit dieser Änderung der Zusammensetzung der Legierung ist eine Verkleinerung Gitterkonstanten $a_{ZS}$ des Legierungsgitters verbunden, wodurch Gitterkonstante $a_{ZS}$ des Legierungsgitters zu Beginn, also im Bereich des Wachstum-Substrats 1 aus Silizium, in etwa der Gitterkonstanten $a_W$ des Wachstum-Substrats 1 entspricht und zu Ende zu, also im Bereich des größten Abstandes der Legierung von dem Wachstum-Substrats 1, in etwa der Gitterkonstanten $a_D$ der auf der Zwischenschicht 10 anschließend abzuscheidenden Diamantschicht 2 entspricht. Dadurch ist die zwischen dem Wachstum-Substrat 1 aus Silizium und der Diamantschicht 2 bestehende Gitterfehlanpassung, die, bezogen auf die Gitterkonstante $a_D$ der Diamantschicht 2 mehr als 50% beträgt, und zu qualitativ minderwertigen Diamantschichten 2 führt, weitgehend abgebaut.

Günstigerweise bleibt bei der Ausbildung der Zwischenschicht 10 als Si-C-Legierung die Kristallstruktur des kristallinen Siliziums erhalten, so daß auf der Legierung ein epitaktisches Wachstum der Diamantschicht 2 ermöglicht ist. Derartig hergestellte Diamantschichten 2 weisen zumindest ein polykristallines Wachstum mit einem hohen Orientierungsgrad auf.

Durch die erfindungsgemäße Modifikation der Gitterkonstanten mittels der Legierung, kann auf der Zwischenschicht 10, die seitens der darauf abzuscheidenden Diamantschicht 2 als Wachstumsseite 3 eines modifizierten Wachstum-Substrats 1 aus Si gesehen werden kann, eine Diamantschicht 2 in guter Qualität abgeschieden werden.

Ein mögliches Verfahren zur Herstellung einer erfindungsgemäßen Komposit-Struktur 11 wird im folgenden beschrieben. Das Wachstum-Substrat 1 wird in einen MBE-Reaktor (molekular-beam-epitaxy) eingebaut und der Reaktor evakuiert. Der Druck im Reaktor sollte weniger als $1*10^{-6}$ mbar betragen. Günstig sind Drücke um ca. $10^{-8}$ mbar. Die Oberfläche des Wachstum-Substrats 1 kann zuvor naßchemisch gereinigt sein. Innerhalb des MBE-Reaktors kann das Wachstum-Substrat 1 nochmals gereinigt werden, wobei dieser Reinigungsschritt in einfacher Weise durch heizen des Wachstum-Substrats 1 auf eine Temperatur über 700 °C erfolgen kann. Des weiteren kann die Reinigung mittels eines durch Radio- oder Mikrowellen erzeugten Plasmas erfolgen. Auch hierbei kann es sinnvoll sein, das Wachstum-Substrat 1 zu erhitzen, und/oder an das Wachstum-Substrat 1 ein bestimmtes elektrisches Potential anzulegen.

Wird die Komposit-Struktur 11 bspw. mit einer mit Mikrowellen unterstützten MWCVD (microwave-chemical-vapor-deposition) hergestellt, kann die Reinigung der Oberfläche des Wachstum-Substrats 1 innerhalb eines derartigen MWCVD-Reaktors auch mittels eines Prozeßgases erfolgen.

Nach der Reinigung des Wachstum-Substrats 1 in dem MBE-Reaktor wird mittels einer Silizium-Feststoffquelle auf der Wachstumsseite 3 des Wachstum-Substrats 1 reines Silizium abgeschieden, das allmählich mit Kohlenstoff versetzt wird, der aus einer Kohlenstoff-Feststoffquelle zugeführt wird. Während der gemischten Abscheidung von Kohlenstoff uns Silizium bildet sich auf dem Wachstum-Substrat 1 eine Silizium-Kohlenstoff-Legierung mit einem zinkblende- bzw. diamantähnlichem Legierungsgitter, in dem die Kohlenstoff- und die Siliziumatome statistisch verteilt sind.

Damit die Gitterkonstante des Legierungsgitters, die zu Beginn der Legierung in etwa der Gitterkonstanten $a_W$ des Wachstum-Substrats 1 aus Silizium entspricht, auf den Wert der Gitterkonstanten $a_D$ eines Diamanten verringert werden kann, wird, durch eine entsprechende Ansteuerung der jeweiligen Feststoffquellen, mit zunehmender Schichtstärke der Legierung der Anteil des Siliziums in der Legierung bis auf ungefähr null verringert, während der Anteil des Kohlenstoffes in der Legierung, also der Zwischenschicht 10 erhöht wird.

Als günstig hat es sich hierbei erwiesen, die Zusammensetzung der Legierung innerhalb einer Dickenerstreckung von etwa 0,1 μm bis 2 μm zu ändern. Die Feststoffquellen bestehen aus Reinstsilizium (99,999%) bzw. aus Reinstkohlenstoff (99,99%). Besonders günstig ist Reinstgraphit. Die Abscheidung der Zwischenschicht erfolgt bei einem Druck im Reaktor von kleiner $10^{-6}$ mbar. Die Temperatur des Wachsstum-Substrats 1 beträgt zwischen 200 °C und 1200 °C, insbesondere zwischen 450 °C und 750 °C. Während des Wachstums kann die Oberfläche der wachsenden Zwischenschicht 10, 30 zusätzlich einem Fluß niedrigenergetischer Ionen, insbesondere Argon- oder Stickstoffionen mit einer mittleren Energie von maximal etwa 100 eV, ausgesetzt werden, um die Oberflächenkinetik der wachsenden Zwischenschicht 10, 30 günstig zu beeinflussen. Zum Schutz kann die Zwischenschicht 10, 30 anschließend mit einer Siliziumschicht abgedeckt werden, die vor der sich anschließenden Diamantabscheidung abgeätzt wird. Hierdurch wird vermieden, daß die Zwischenschicht 10, 30 zu Beginn des Diamantwachstums entfernt wird.

Die Abscheidung der Diamantschicht erfolgt bei einem Wasserstoff/Methan-Gasstrom, der zwischen 0,1 und 10 % Methan aufweist, einer Temperatur zwischen 200 °C und 900 °C, bevorzugt über 600 °C. Die Keimbildungsphase kann hierbei durch das Anlegen einer BIAS-Spannung zwischen + 50 V bis -300 V, insbesondere bei - 150 V unterstützt werden.

Die Vorteilhaftigkeit des erfindungsgemäße Verfahrens zeigt sich u.a. daran, daß damit hergestellte Komposit-Substrate 11 eine modifizierte Gitterfehlanpassung beim Übergang zwischen den jeweiligen Schichten aufweisen, die geringer 5%, insbesondere geringer 3% sind.

Ein weiteres Ausführungsbeispiel einer erfindungsgemäßen Komposit-Struktur 31 ist in Figur 3 und der Verlauf von deren Gitterkonstanten entlang der Dickenerstreckung der Komposit-Struktur 31 in Figur 4 dargestellt. Um unnötige Wiederholungen zu vermeiden, wird nur noch auf die Unterschiede zu dem Ausführungsbeispiel nach den Figuren 1 und 2 eingegangen.

Die Zwischenschicht 30 dieses Ausführungsbeispieles ist durch einen Bereich des Wachstum-Substrats 1 gebildet, in dem Kohlenstoffatome angeordnet sind. Diese Kohlenstoffatome bewirken eine Änderung der Gitterkonstanten $a_W$ des Wachstum-Substrats 1 in diesem Bereich, wobei die Gitterstruktur des Wachstum-Substrats 1 erhalten weitgehend bleibt. Die derartige Wachstumsseite 3 des Wachstum-Substrats 1 weist im vorliegenden Ausführungsbeispiel eine Gitterkonstante $a_{ZS}$ auf, die mit der Gitterkonstanten $a_D$ der darauf abzuscheidenden Diamantschicht 2 ein Verhältnis von etwa 2:3 aufweist. Es handelt sich also um eine modifizierte Gitteranpassung zwischen einer durch in die Oberfläche des Wachstum-Substrats 1 eingelagerte Kohlenstoffatome gebildete Zwischenschicht 30 und der Diamantschicht 2.

Die Herstellung einer derartigen Zwischenschicht 30 erfolgt sinnvollerweise dadurch, daß die Kohlenstoffatome in an sich bekannter Weise in die Wachstumsseite 3 des Wachstum-Substrats 1 eindiffundiert oder mittels Ionenimplantation eingebracht werden. Da sowohl das Maximum des Diffusionsprofils als auch das Maximum des Implantationsprofils einige Atomlagen unterhalb der Oberfläche der behandelten Fläche des Wachstum-Substrats 1 angeordnet ist, ist es in beiden Fällen sinnvoll, einige Atomlagen dieser Oberfläche zu entfernen, bis die neue Oberfläche eine Gitterkonstante aufweist, mit der eine entsprechend modifizierte Gitteranpassung möglich ist. Die Entfernung dieses Oberflächenbereiches um die bestimmte Schichtstärke erfolgt zweckmäßigerweise mittels Ätzen.

## Patentansprüche

1. Komposit-Struktur für elektronische Bauteile mit einem Wachstum-Substrat (1), mit einer auf dem Wachstum-Substrat (1) angeordneten und im wesentlichen eine kristallographische Gitterstruktur aufweisenden Zwischenschicht (10, 30) und einer auf der Zwischenschicht (10, 30) aufgebrachten Diamantschicht (2), wobei

   - die Zwischenschicht (10, 30) eine Legierung mit einer statistischen Verteilung der Legierungsatome im Legierungsgitter ist,
   - sich die Zusammensetzung der Legierungsatome entlang der Dickenerstreckung der Zwischenschicht (10, 30) kontinuierlich verändert,
   - das Legierungsgitter in kristallographischer Hinsicht im wesentlichen eine Zinkblenden- oder Diamant- oder Calziumfluorid (CaF$_2$)-struktur aufweist,
   - die Zwischenschicht eine feste Orientierung des Kristallgitters der Zwischenschicht (10, 30) zum Kristallgitter des Wachstumssubstrats (1) aufweist,

- beim Übergang der Zwischenschicht (10, 30) zum Wachstumssubstrat (1) die Differenz zwischen der Gitterkonstanten ($a_{ZS}$) der Zwischenschicht (10, 30) und der Gitterkonstanten ($a_{WS}$) des Wachstum-Substrats (1), bezogen auf die Gitterkonstante ($a_{ZS}$) des Zwischenschicht (10, 30), kleiner als 20% ist, und

- beim Übergang der Zwischenschicht (10, 30) zu der Diamantschicht (2) hin für die Gitterkonstante ($a_{ZS}$) der Zwischenschicht (10, 30) und der Gitterkonstanten ($a_D$) der Diamantschicht (2) der Wert des Ausdrucks

$$\left| (n^*a_{ZS} - m^*a_D) \right| / n^*a_{ZS}$$

kleiner als 0,2 ist, wobei gilt:

n und m sind natürliche Zahlen,
$a_D$ ist die Gitterkonstante der Diamantschicht (2) und
$a_{ZS}$ ist die Gitterkonstante der Zwischenschicht (10, 30) am Übergang zu der Diamantschicht (2).

2. Komposit-Struktur nach Anspruch 1,
**dadurch gekennzeichnet,**
daß beim Übergang der Zwischenschicht (10, 30) zum Wachstums-substrat (1) die Differenz zwischen der Gitterkonstanten ($a_{ZS}$) der Zwischenschicht (10, 30) und der Gitterkonstanten ($a_{WS}$) des Wachstum-Substrats (1), bezogen auf die Gitterkonstante ($a_{ZS}$) des Zwischenschicht (10, 30), kleiner als 10% ist.

3. Komposit-Struktur nach Anspruch 1,
**dadurch gekennzeichnet,**
daß der Wert des Ausdrucks

$$\left| (n^*a_{ZS} - m^*a_D) \right| / n^*a_{ZS}$$

kleiner als 0,1 ist.

4. Komposit-Struktur nach Anspruch 1,
**dadurch gekennzeichnet,**
daß die einzelnen Kristallite der Diamantschicht mit Abmessungen zwischen 0,1 μm bis 200 μm zwischen 20 % und 100 % am Kristallgitter der Zwischenschicht (10, 30) ausgerichtet sind.

5. Komposit-Struktur nach Anspruch 1,
**dadurch gekennzeichnet,**
daß die durch die Miller'schen Indizes (hkl) gekennzeichneten Kristallrichtungen der Kristallite der Diamantschicht und der Zwischenschicht (10, 30) um maximal zehn Grad gegeneinander geneigt sind.

6. Komposit-Struktur nach Anspruch 1,
**dadurch gekennzeichnet,**
daß die Legierung Kohlenstoff aufweist und daß der Kohlenstoffanteil innerhalb der Zwischenschicht (10, 30) mit zunehmendem Abstand vom Wachstum-Substrat (1) zunimmt.

7. Komposit-Struktur nach Anspruch 1,
**dadurch gekennzeichnet,**
daß das Wachstum-Substrat (1) aus weitgehend monokristallinem Silizium oder Galliumarsenid gebildet ist.

8. Komposit-Struktur nach Anspruch 1,
**dadurch gekennzeichnet,**
daß das Wachstum-Substrat (1) aus weitgehend monokristallinem Silizium gebildet ist, daß die Legierung eine Silizium-Kohlenstoff-Legierung mit einer statistischen Verteilung der Legierungsatome im Legierungsgitter ist und daß der Siliziumanteil innerhalb der Zwischenschicht (10, 30) mit zunehmendem Abstand von den Wachstum-Substrat (1) abnimmt.

9. Komposit-Struktur nach Anspruch 1,
**dadurch gekennzeichnet,**
daß die Zwischenschicht (30) durch einen Oberflächenbereich des Wachstum-Substrats (1) gebildet ist, in der Kohlenstoff eingelagert ist.

10. Verfahren zur Herstellung einer Komposit-Struktur für elektronische Bauteile, bei dem die Oberfläche eines Wachstum-Substrats (1) gereinigt wird, bei dem auf eine Wachstumsseite des Wachstum-Substrats (1) eine Zwischenschicht (10, 30) mit kristallographischer Gitterstruktur aufgebracht wird und bei dem auf der Zwischenschicht (10, 30) eine Diamantschicht (2) aufgebracht wird, wobei

- als Zwischenschicht (10, 30) eine Legierung mit einer statistischen Verteilung der Legierungsatome im Legierungsgitter aufgebracht wird,
- die Zusammensetzung der Legierungsatome entlang der Dickenerstreckung der Zwischenschicht (10, 30) kontinuierlich verändert wird,
- die Zwischenschicht mit einer festen Orientierung des Kristallgitters der Zwischenschicht (10, 30) zum Kristallgitter des Wachstumssubstrats (1) aufgebracht wird,
- die Zwischenschicht (10, 30) im wesentlichen mit einer Zinkblende- oder Diamant- oder Calziumfluorid (CaF$_2$)-struktur aufgebracht wird,
- die Zwischenschicht (10, 30) beim Übergang der Zwischenschicht (10, 30) zum Wachstums-Substrat (1) mit einer Differenz zwischen der Gitterkonstanten ($a_{ZS}$) der Zwischenschicht (10, 30) und der Gitterkonstanten ($a_{WS}$) des Wachstum-Substrats (1), bezogen auf die Gitterkonstante ($a_{ZS}$) des Zwischenschicht (10, 30) aufgebracht wird, die kleiner als 20%, und

- die Legierung beim Übergang der Zwischenschicht (10, 30) zu der Diamantschicht (2) hin derart aufgebracht wird, daß für die Gitterkonstante ($a_{ZS}$) der Zwischenschicht (10, 30) und die Gitterkonstanten ($a_D$) der Diamantschicht (2) der Wert des Ausdrucks

$$\left| (n^*a_{ZS} - m^*a_D) \right| / n^*a_{ZS}$$

kleiner als 0,2 gilt, wobei

| | |
|---|---|
| n und m | natürliche Zahlen sind, |
| $a_D$ | die Gitterkonstante der Diamantschicht (2) ist und |
| $a_{ZS}$ | die Gitterkonstante der Zwischenschicht (10, 30) am Übergang zu der Diamantschicht (2) ist. |

11. Verfahren nach Anspruch 10,
**dadurch gekennzeichnet,**
daß die Zwischenschicht (10, 30) beim Übergang der Zwischenschicht (10, 30) zum Wachstums-Substrat (1) mit einer Differenz zwischen der Gitterkonstanten ($a_{ZS}$) der Zwischenschicht (10, 30) und der Gitterkonstanten ($a_{WS}$) des Wachstum-Substrats (1), bezogen auf die Gitterkonstante ($a_{ZS}$) des Zwischenschicht (10, 30) aufgebracht wird, die kleiner als 10% ist.

12. Verfahren nach Anspruch 10,
**dadurch gekennzeichnet,**
daß die Legierung derart aufgebracht wird, daß der Wert des Ausdrucks

$$\left| (n^*a_{ZS} - m^*a_D) \right| / n^*a_{ZS}$$

kleiner als 0,1 ist.

13. Verfahren nach Anspruch 10,
**dadurch gekennzeichnet,**
daß als Zwischenschicht (10, 30) eine Kohlenstoff aufweisende Legierung aufgebracht wird, deren Kohlenstoffanteil mit zunehmender Dickenerstreckung der Zwischenschicht (10, 30) erhöht wird.

14. Verfahren nach Anspruch 10,
**dadurch gekennzeichnet,**
daß ein Wachstum-Substrat (1) aus weitgehend monokristallinem Silizium verwandt wird, daß als Zwischenschicht (10, 30) eine Silizium-Kohlenstoff-Legierung mit einer statistischen Verteilung der Legierungsatome im Legierungsgitter aufgebracht wird, und daß der Siliziumanteil mit zunehmendem Abstand der Zwischenschicht (10, 30) vom Wachstum-Substrat (1) verringert wird.

15. Verfahren nach Anspruch 10,
**dadurch gekennzeichnet,**
daß zur Bildung der Zwischenschicht (30) in die Wachstumsseite des Wachstum-Substrats (1) Kohlenstoffatome eingelagert werden.

16. Verfahren nach Anspruch 15,
**dadurch gekennzeichnet,**
daß die Kohlenstoffatome mittels Ionenimplantation und/oder mittels Diffusion eingelagert werden.

17. Verfahren nach Anspruch 15 oder 16,
**dadurch gekennzeichnet,**
daß nach der Einlagerung der Kohlenstoffatome die Wachstumsseite des Wachstum-Substrats (1) um eine bestimmte Schichtstärke abgetragen wird.

18. Verfahren nach Anspruch 15 oder 16,
**dadurch gekennzeichnet,**
daß die Wachstumsseite des Wachstum-Substrats (1) um eine bestimmte Schichtstärke abgeätzt wird.

19. Verfahren nach Anspruch 10,
**dadurch gekennzeichnet,**
daß die Zwischenschicht (10, 30) und/oder die Diamantschicht (2) mittels MBE mit an sich bekannten Feststoffquellen aufgebracht wird.

20. Verfahren nach Anspruch 10,
**dadurch gekennzeichnet,**
daß zur Herstellung einer Zwischenschicht (10, 30) auf einem Wachstum-Substrat (1) aus Silizium zuerst eine Substanz beigegeben wird, die auf der Wachstumsseite (3) des Wachstum-Substrats (1) eine reine Siliziumschicht abscheidet und deren Anteil mit zunehmendem Abstand der Zwischenschicht (10, 30) vom Wachstum-Substrat (1) verringert wird und daß mit zunehmender Dickenerstreckung der Zwischenschicht (10, 30) wenigstens eine weitere an sich bekannte Substanz beigegeben wird, mit der der Zwischenschicht (10, 30) Kohlenstoff beigemengt wird und deren Anteil mit zunehmender Dickenerstreckung der Zwischenschicht (10, 30) erhöht wird.

21. Verfahren nach Anspruch 10,
**dadurch gekennzeichnet,**
daß während des Abscheidens der Zwischenschicht (10, 30) diese von einem Fluß niederenergetischer Ionen beaufschlagt wird.

22. Verfahren nach Anspruch 21,
**dadurch gekennzeichnet,**
daß als niederenergetische Ionen Stickstoff- und/oder Argonionen verwendet werden.

23. Verfahren nach Anspruch 10, **dadurch gekennzeichnet,** daß nach dem Abscheiden der Zwischenschicht (10, 30) dieser mit einer Schicht bedeckt wird und daß diese Schicht vor der Abscheidung der Diamantschicht (2) entfernt wird.

24. Verfahren nach Anspruch 23, **dadurch gekennzeichnet,** daß die Schicht vor der Abscheidung der Diamantschicht (2) abgeätzt wird.

25. Verfahren nach Anspruch 10, **dadurch gekennzeichnet,** daß die Zwischenschicht (10, 30) auf ihrer von dem Wachstumssubstrat (1) abgewandten Seite vor dem Abscheiden der Diamantschicht (2) mit einer Rauhigkeit von größer 5 nm abgeschieden wird.

26. Verfahren nach Anspruch 10, **dadurch gekennzeichnet,** daß zur Förderung des Keimbildungsprozesses die Oberflächenenergie der Zwischenschicht (10, 30) gegenüber der Oberflächenenergie des Wachstum-Substrats (1) erhöht wird.

## Claims

1. A composite structure for electronic components with a growth substrate (1), with an intermediate layer (10, 30) located on the growth substrate (1) having an essentially crystallographic lattice structure and with a diamond layer (2) applied to the intermediate layer (10, 20), whereby

   - the intermediate layer (10, 30) is an alloy with a statistical distribution of alloy atoms in the alloy lattice,
   - the composition of the alloy atoms through the depth of the intermediate layer (10, 30) changes continuously,
   - in crystallographic terms, the structure of the alloy lattice is essentially similar to that of zinc blende or diamond or calcium fluoride ($CaF_2$),
   - the orientation of the crystal lattice of the intermediate layer (10, 30) in relation to the crystal lattice of the growth substrate (1) is fixed,
   - at the transition from the intermediate layer (10, 30) to the growth substrate (1), the difference between the lattice constant ($a_{ZS}$) of the intermediate layer (10, 30) and the lattice constant ($a_{WS}$) of the growth substrate (1), relative to the lattice constant ($a_{ZS}$) of the intermediate layer (10, 30), is less than 20% and
   - at the transition from the intermediate layer (10, 30) to the diamond layer (2), the value of the expression

   $$\left| (n^{*}a_{ZS} - m^{*}a_{D}) \right| / n^{*}a_{ZS}$$

   for the lattice constant ($a_{ZS}$) of the intermediate layer (10, 30) and the lattice constant ($a_{D}$) of the diamond layer (2) is less than 0.2 where:

   $n$ and $m$    are natural numbers,
   $a_{D}$    is the lattice constant of the diamond layer (2) and
   $a_{ZS}$    is the lattice constant of the intermediate layer (10, 30) at the transition to the diamond layer (2).

2. A composite structure in accordance with Claim 1, **characterised in that,** at the transition from the intermediate layer (10, 30) to the growth substrate (1), the difference between the lattice constant ($a_{ZS}$) of the intermediate layer (10, 30) and the lattice constant (aws) of the growth substrate (1), relative to the lattice constant ($a_{ZS}$) of the intermediate layer (10, 30), is less than 10%.

3. A composite structure in accordance with Claim 1, **characterised in that** the value of the expression

   $$\left| (n^{*}a_{ZS} - m^{*}a_{D}) \right| / n^{*}a_{ZS}$$

   is less than 0.1.

4. A composite structure in accordance with Claim 1, **characterised in that** the individual crystallites in the diamond layer have dimensions of between 0.1 μm and 200 μm and are aligned between 20% and 100% with the crystal lattice of the intermediate layer (10, 30).

5. A composite structure according to Claim 1, **characterised in that** the crystal orientations of the crystallites in the diamond layer and the intermediate layer (10, 30) characterised by the Miller's indices (hkl) stand at an angle of no more than ten degrees in relation to one another.

6. A composite structure according to Claim 1, **characterised in that** the alloy contains carbon and that the carbon content in the intermediate layer (10, 30) increases as its distance from the growth substrate increases (1).

7. A composite structure according to Claim 1, **characterised in that** the growth substrate (1) is made of largely monocrystallised silicon or gallium arsenide.

8. A composite structure according to Claim 1, **characterised in that** the growth substrate (1) is made of largely monocrystallised silicon, that the alloy is a silicon/carbon alloy with a statistical distribution of alloy atoms in the alloy lattice and that the silicon content in the intermediate layer (10, 30) decreases as the distance from the growth substrate (1) increases.

9. A composite structure according to Claim 1, **characterised in that** the intermediate layer (10, 30) if formed by an area of the surface of the growth substrate (1) into which carbon has been introduced.

10. A process for the manufacture of a composite structure for electronic components in which the surface of a growth substrate (1) is cleaned, in which an intermediate layer (10, 30) with a crystallographic lattice structure is applied to a growth side of the growth substrate (1) and in which a diamond layer (2) is applied to the intermediate layer (10, 20), whereby

   - an alloy with a statistical distribution of alloy atoms in the alloy lattice is applied as the intermediate layer (10, 30),
   - the composition of the alloy atoms through the depth of the intermediate layer (10, 30) changes continuously,
   - the intermediate layer is applied with a fixed orientation of the crystal lattice of the intermediate layer (10, 30) in relation to the crystal lattice of the growth substrate (1),
   - the intermediate layer (10, 30) is essentially applied with a zinc blende or diamond or calcium fluoride ($CaF_2$) structure,
   - at the transition from the intermediate layer (10, 30) to the growth substrate (1), the intermediate layer (10, 30) is applied with a difference between the lattice constant ($a_{ZS}$) of the intermediate layer (10, 30) and the lattice constant (aws) of the growth substrate (1), relative to the lattice constant ($a_{ZS}$) of the intermediate layer (10, 30), of less than 20% and
   - at the transition from the intermediate layer (10, 30) to the diamond layer (2), the alloy is applied in such a manner that for the lattice constant ($a_{ZS}$) of the intermediate layer (10, 30) and the lattice constant (aD) of the diamond layer (2) the value of the expression

$$\left| (n^*a_{ZS} - m^*a_D) \right| / n^*a_{ZS}$$

   is less than 0.2, where:

   n and m   are natural numbers,

$a_D$   is the lattice constant of the diamond layer (2) and

$a_{ZS}$   is the lattice constant of the intermediate layer (10, 30) at the transition to the diamond layer (2).

11. A process in accordance with Claim 10, **characterised in that,** at the transition from the intermediate layer (10, 30) to the growth substrate (1), the intermediate layer (10, 30) is applied with a difference between the lattice constant (aZS) of the intermediate layer (10, 30) and the lattice constant (aWS) of the growth substrate (1), relative to the lattice constant (aZS) of the intermediate layer (10, 30), of less than 10%.

12. A process in accordance with Claim 10, **characterised in that** the alloy is applied in such a manner that the value of the expression

$$\left| (n^*a_{ZS} - m^*a_D) \right| / n^*a_{ZS}$$

   is less than 0.1.

13. A process in accordance with Claim 10, **characterised in that** an alloy containing carbon with a carbon content which increases as the depth of the intermediate layer (10, 30) increases is applied as the intermediate layer (10, 30).

14. A process in accordance with Claim 10, **characterised in that** a growth substrate (1) made of largely monocrystallised silicon is used, that a silicon/carbon alloy with a statistical distribution of alloy atoms in the alloy lattice is applied as the intermediate layer (10, 30), and that the silicon content is reduced as the distance between the intermediate layer (10, 30) and the growth substrate (1) increases.

15. A process in accordance with Claim 10, **characterised in that,** in order to form the intermediate layer (10, 30), carbon atoms are introduced into the growth side of the growth substrate (1).

16. A process in accordance with Claim 15, **characterised in that** the carbon atoms are introduced by means of ion implantation and/or by means of diffusion.

17. A process in accordance with Claim 15 or 16, **characterised in that,** after the introduction of the carbon atoms, a specific thickness of the surface of the growth side of the growth substrate (1) is removed.

18. A process in accordance with Claim 15 or 16, **characterised in that** a specific thickness of the growth side of the growth substrate (1) is removed by etching.

19. A process in accordance with Claim 10, **characterised in that** the intermediate layer (10, 30) and/or the diamond layer (2) is/are applied by means of MBE with known sources of solid materials.

20. A process in accordance with Claim 10, **characterised in that,** in order to manufacture an intermediate layer (10, 30), first a substance which deposits a layer of pure silicon onto the growth side (3) of the growth substrate (1) and whose content decreases as the distance between the intermediate layer (10, 30) and the growth substrate (1) increases is applied to a growth substrate (1) made of silicon and that, as the depth of the intermediate layer (10, 30) increases, at least one further, known substance is applied by means of which carbon is added to the intermediate layer (10, 30) and whose content increases as the depth of the intermediate layer (10, 30) increases.

21. A process in accordance with Claim 10, **characterised in that,** during the deposition of the intermediate layer (10, 30), the latter is exposed to a flow of low energy ions.

22. A process in accordance with Claim 21, **characterised in that** nitrogen and/or argon ions are used as the low energy ions.

23. A process in accordance with Claim 10, **characterised in that,** after the deposition of the intermediate layer (10, 30), the latter is covered with a layer and that this layer is removed before the deposition of the diamond layer (2).

24. A process in accordance with Claim 23, **characterised in that** the layer is removed by etching prior to the deposition of the diamond layer (2).

25. A process in accordance with Claim 10, **characterised in that,** prior to the deposition of the diamond layer (2), the side of the intermediate layer (10, 30) facing away from the growth substrate (1) is deposited with a roughness of greater than 5 nm.

26. A process in accordance with Claim 10, **characterised in that** in order to promote the nucleation process, the surface energy of the intermediate layer (10, 30) is increased in relation to the surface energy of the growth substrate (1).

## Revendications

1. Structure composite pour composant électronique avec un substrat de croissance (1), avec une couche intermédiaire (10, 30) arrangée sur le substrat de croissance (1) et présentant essentiellement une structure de réseau cristallin et une couche de diamant (2) fournie sur la couche intermédiaire (10, 30), dans laquelle

   - la couche intermédiaire (10, 30) est un alliage avec une répartition statistique des atomes d'alliage dans le réseau cristallin de l'alliage,
   - la composition de structure des atomes d'alliage se modifie de manière continue selon l'épaisseur de la couche intermédiaire (10, 30),
   - le réseau cristallin de l'alliage au point de vue cristallographique, présente essentiellement une structure de blende - ou de diamant - ou de fluorure de calcium ($CaF_2$),
   - la couche intermédiaire présente une orientation fixe du réseau cristallin de la couche intermédiaire (10, 30) par rapport au réseau cristallin de la couche du substrat de croissance (1),
   - à la transition de la couche intermédiaire (10, 30) vers le substrat de croissance (1), la différence entre la constante de réseau ($a_{ZS}$) de la couche intermédiaire (10, 30) et la constante de réseau ($a_{WS}$) du substrat de croissance (1), rapportée à la constante de réseau ($a_{ZS}$) de la couche intermédiaire (10, 30), est inférieure à 20%, et
   - à la transition de la couche intermédiaire (10, 30) vers la couche de diamant (2), pour la constante de réseau ($a_{ZS}$) de la couche intermédiaire (10, 30) et la constante de réseau ($a_D$) de la couche de diamant (2), la valeur de l'expression

$$|(n{*}a_{ZS} - m{*}a_D)|/n{*}a_{ZS}$$

   est inférieure à 0,2, où :

   n et m     sont des entiers naturels,
   $a_D$       est la constante de réseau de la couche de diamant (2) et
   $a_{ZS}$      est la constante de réseau de la couche intermédiaire (10, 30) à la transition vers la couche de diamant (2).

**2.** Structure composite selon la revendication 1, caractérisée en ce que, à la transition de la couche intermédiaire (10, 30) vers le substrat de croissance (1), la différence entre la constante de réseau ($a_{ZS}$) de la couche intermédiaire (10, 30) et la constante de réseau ($a_{WS}$) du substrat de croissance (1), rapportée à la constante de réseau ($a_{ZS}$) de la couche intermédiaire (10, 30), est inférieure à 10%.

**3.** Structure composite selon la revendication 1, caractérisée en ce que la valeur de l'expression

$$\left|(n^{*}a_{ZS} - m^{*}a_{D})\right|/n^{*}a_{ZS}$$

est inférieure à 0,1.

**4.** Structure composite selon la revendication 1, caractérisée en ce que, les cristaux particuliers de la couche de diamant ayant une dimension comprise entre 0,1 µm et 200 microns sont entre 20% et 100% orientés selon la couche du réseau cristallin de la couche intermédiaire (10, 30).

**5.** Structure composite selon la revendication 1, caractérisée en ce que les directions cristallographiques caractérisées par les indices de Miller (hkl) des cristaux de la couche de diamant et de la couche intermédiaire (10, 30) sont inclinées de 10 degrés maximum l'une par rapport à l'autre.

**6.** Structure composite conforme à la revendication 1, caractérisée en ce que l'alliage comporte du carbone et que la proportion de carbone à l'intérieur de la couche intermédiaire (10, 30) augmente lorsque la distance au substrat de croissance (1) augmente.

**7.** Structure composite selon la revendication 1, caractérisée en ce que le substrat de croissance (1) est formé essentiellement de silicium monocristallin ou d'arséniure de gallium.

**8.** Structure composite selon la revendication 1, caractérisée en ce que, le substrat de croissance (1) est formé essentiellement de silicium monocristallin, l'alliage est un alliage de silicium-carbone avec une répartition statistique des atomes d'alliage dans le réseau cristallin de l'alliage, et la proportion de silicium à l'intérieur de la couche intermédiaire (10, 30) décroît lorsque la distance au substrat de croissance (1) augmente.

**9.** Structure composite selon la revendication 1, caractérisée en ce que la couche intermédiaire (30) est formée d'une étendue en surface du substrat de croissance (1) dans laquelle du carbone est déposé.

**10.** Procédé pour fabriquer une structure composite pour composant électronique, dans lequel la surface d'un substrat de croissance (1) est nettoyée, dans lequel sur un côté de croissance du substrat de croissance (1) une couche intermédiaire (10, 30) ayant une structure de réseau cristallin est fournie, et dans lequel une couche de diamant (2) est fournie sur la couche intermédiaire (10, 30), dans lequel

- un alliage avec une répartition statistique des atomes d'alliage dans le réseau cristallin de l'alliage est fourni comme couche intermédiaire (10, 30)
- la composition de structure des atomes d'alliage change de manière continue selon l'épaisseur de la couche intermédiaire (10, 30),
- la couche intermédiaire est fournie avec une orientation fixe du réseau cristallin de la couche intermédiaire (10, 30) par rapport au réseau cristallin du substrat de croissance (1),
- la couche intermédiaire (10, 30) est fournie essentiellement avec une structure de blende - ou de diamant - ou de fluorure de calcium ($CaF_2$),
- à la transition de la couche intermédiaire (10, 30) vers le substrat de croissance (1), la couche intermédiaire (10, 30) est fournie avec une différence entre la constante de réseau ($a_{ZS}$) de la couche intermédiaire (10, 30) et la constante de réseau ($a_{WS}$) du substrat de croissance (1), rapportée à la constante de réseau ($a_{ZS}$) de la couche intermédiaire (10, 30), qui est inférieure à 20%, et
- à la transition de la couche intermédiaire (10, 30) vers la couche de diamant (2), l'alliage est fourni de telle manière que, pour la constante de réseau ($a_{ZS}$) de la couche intermédiaire (10, 30) et la constante de réseau ($a_D$) de la couche de diamant (2), la valeur de l'expression

$$\left|(n^{*}a_{ZS} - m^{*}a_{D})\right|/n^{*}a_{ZS}$$

est inférieure à 0,2, où :

n et m sont des entiers naturels,

$a_D$ est la constante de réseau de la couche de diamant (2) et

$a_{ZS}$ est la constante de réseau de la couche intermédiaire (10, 30) à la transition vers la couche de diamant (2).

**11.** Procédé selon la revendication 10, caractérisé en ce que, à la transition de la couche intermédiaire (10, 30) vers le substrat de croissance (1), la couche intermédiaire (10, 30) est fournie avec une différence entre la constante de réseau ($a_{ZS}$) de la couche intermédiaire (10, 30) et la constante de réseau ($a_{WS}$) du substrat de croissance (1), rapportée à la constante de réseau ($a_{ZS}$) de la couche intermédiaire (10, 30), qui est inférieure à 10%.

12. Procédé selon la revendication 10, caractérisé en ce que, l'alliage est fourni de telle manière que la valeur de l'expression

$$\left|(n^* a_{ZS} - m^* a_D)\right|/n^* a_{ZS}$$

soit inférieure à 0,1.

13. Procédé selon la revendication 10, caractérisé en ce que, un alliage contenant du carbone est fourni comme couche intermédiaire (10, 30), dont la proportion de carbone augmente lorsque l'épaisseur de la couche intermédiaire (10, 30) augmente

14. Procédé selon la revendication 10, caractérisé en ce que, un substrat de croissance (1) formé essentiellement de silicium monocristallin est utilisé, un alliage silicium-carbone avec une répartition statistique des atomes d'alliage dans le réseau cristallin de l'alliage est fourni comme couche intermédiaire (10, 30), et la proportion de silicium diminue lorsque la distance de la couche intermédiaire (10, 30) au substrat de croissance (1) augmente.

15. Procédé selon la revendication 10, caractérisé en ce que, pour la formation de la couche intermédiaire (30) des atomes de carbone sont déposés dans le côté de croissance du substrat de croissance (1).

16. Procédé selon la revendication 15, caractérisé en ce que, les atomes de carbone sont déposés par mise en oeuvre d'une technique d'implantation ionique et/ ou d'une technique de diffusion.

17. Procédé selon la revendication 15 ou la revendication 16, caractérisé en ce que, après le dépôt des atomes de carbone, une épaisseur de couche déterminée est ôtée par érosion du côté de croissance du substrat de croissance (1).

18. Procédé selon la revendication 15 ou la revendication 16, caractérisé en ce que, une épaisseur de couche déterminée est ôtée par attaque chimique du côté de croissance au substrat de croissance (1).

19. Procédé selon la revendication 10, caractérisé en ce que, la couche intermédiaire (10, 30) et/ ou la couche de diamant (2) est fournie au moyen d'une technique MBE (épitaxie par faisceau de molécules) avec une source de matière solide connue en soi.

20. Procédé selon la revendication 10, caractérisé en ce que, pour la fabrication d'une couche intermédiaire (10, 30) sur un substrat de croissance (1) en silicium, une matière est tout d'abord ajoutée, qui dépose une couche de silicium propre sur le côté de croissance du substrat de croissance (1) et dont la proportion diminue lorsque la distance de la couche intermédiaire (10, 30) au substrat de croissance (1) augmente et, lorsque de l'épaisseur de la couche intermédiaire (10, 30) augmente; au moins une autre matière connue en soi est ajoutée, grâce à laquelle du carbone est mélangé à la couche intermédiaire (10, 30) et dont la proportion augmente lorsque l'épaisseur de la couche intermédiaire (10, 30) augmente.

21. Procédé selon la revendication 10, caractérisé en ce que, pendant le dépôt de la couche intermédiaire (10, 30) celle-ci est implantée par un écoulement d'ions de basse énergie.

22. Procédé selon la revendication 21, caractérisé en ce que, des ions d'azote et/ ou d'argon sont utilisés comme ions de basse énergie.

23. Procédé selon la revendication 10, caractérisé en ce que, après le dépôt de la couche intermédiaire (10, 30), celle-ci est recouverte d'une couche, et cette couche est éliminée avant le dépôt de la couche de diamant (2).

24. Procédé selon la revendication 23, caractérisé en ce que, la couche avant dépôt de la couche de diamant (2) est ôtée par attaque chimique.

25. Procédé selon la revendication 10, caractérisé en ce que, sur son côté utilisé comme substrat de croissance (1), la couche intermédiaire (10, 30) est déposée avec une rugosité supérieure à 5 nm avant le dépôt de la couche de diamant (2).

26. Procédé selon la revendication 10, caractérisé en ce que, pour favoriser le processus de formation des germes, l'énergie superficielle de la couche intermédiaire (10, 30) est élevée au-dessus de l'énergie superficielle du substrat de croissance (1).

# Figur 1

# Figur 2

# Figur 3

# Figur 4